# EUROPÄISCHE PATENTSCHRIFT

(11) **EP 3 153 270 B1**
(45) Veröffentlichungstag und Bekanntmachung des Hinweises auf die Patenterteilung: **18.12.2019**
(21) Anmeldenummer: 16180269.9
(22) Anmeldetag: 20.07.2016
(51) Int. Cl.: B23K 101/42, B23K 3/06, B23K 3/08, H05K 13/04, H05K 3/34, B23K 1/08

(54) **LÖTMODUL MIT MINDESTENS ZWEI LÖTTIEGELN**
SOLDERING MODULE WITH AT LEAST TWO SOLDER POTS
MODULE DE BRASAGE AVEC AU MOINS DEUX CRÉUSETS

(30) Priorität: 09.10.2015 DE 102015219611
(43) Veröffentlichungstag der Anmeldung: 12.04.2017
(73) Patentinhaber: Ersa GmbH, 97877 Wertheim (DE)
(72) Erfinder: KURTZ, Rainer, 97877 Wertheim (DE); SCHÄFER, Michael, 97900 Külsheim (DE)
(74) Vertreter: DREISS Patentanwälte PartG mbB

(56) Entgegenhaltungen:
- EP-A2- 0 311 393
- WO-A1-2014/086954
- DE-A1-102006 021 946

## Beschreibung

Die Erfindung betrifft ein Lötmodul für eine Lötanlage zum selektiven Wellenlöten mit wenigstens einem ersten und einem zweiten Löttiegel, wobei die Löttiegel mittels eines X-Achsenantriebs entlang einer X-Achse verlagerbar sind, mittels eines Y-Achsenantriebs entlang einer Y-Achse verlagerbar sind, und mittels eines Z-Achsenantriebs entlang einer Z-Achse verlagerbar sind, wobei die Achsen jeweils orthogonal zueinander angeordnet sind.

Im Bereich der Kontaktierung von elektronischen Bauelementen, welche beispielsweise mittels Through Hole Technology (THT) von einer Oberseite einer Leiterkarte durch eine Bohrung in der Leiterkarte befestigt werden, ist es bekannt, die Bauelemente von einer Unterseite der Leiterkarte zu Kontaktieren.

Zur Kontaktierung einzelner Pins oder Pinreihen durch Löten ist das sogenannte selektive Wellenlöten bekannt geworden, bei dem eine Baugruppe bzw. ein zu kontaktierender Pin exakt über einer stehenden Welle eines flüssigen Lots positioniert wird. Dabei ist es ferner bekannt, beim sogenannten Fluxen zunächst mit einer Sprühdüse ein Flussmittel zur Verbesserung der Benetzung durch das Lot auf die zu verlötenden Pins/Pinreihen aufzusprühen, wobei dann einzelne Pins durch das sogenannte Punktlöten oder Pinreihen durch Verfahren einer Bahn vom ersten bis zum letzten Pin der Pinreihe verlötet werden.

Dabei ist es beispielsweise bekannt, eine Leiterkarte mit einer Positioniereinrichtung exakt über einer stehenden Welle eines statisch in einer Lötanlage angeordneten Löttiegels zu positionieren und zum Punktlöten dann gegebenenfalls abzusenken, bis die stehende Welle des Lots den Pin kontaktiert. In diesem Fall wird somit die gesamte Leiterkarte relativ gegenüber der im statischen Löttiegel erzeugten stehenden Welle verschoben. Eine derartige Vorgehensweise hat sich jedoch als vergleichsweise zeitintensiv erwiesen.

Aus dem Stand der Technik sind ferner Lötmodule nach dem Oberbegriff des Anspruchs 1 bekannt, wobei die Löttiegel relativ zu einer zu bearbeitenden, während der Bearbeitung statisch angeordneten Leiterkarte in Richtung der X-Achse, der Y-Achse und der Z-Achse verfahren werden können. Dabei ist es jedoch im Stand der Technik nur möglich, beide Löttiegel synchron zueinander zu verfahren, da beide Löttiegel von einem gemeinsamen Y-Achsenantrieb in Richtung der Y-Achse bewegt werden und somit auch nur eine gemeinsame Bewegung der Löttiegel in Richtung der X-Achse ermöglicht ist. Aus dem Stand der Technik ist es daher lediglich bekannt, die Löttiegel unabhängig voneinander in Richtung einer Z-Achse, d.h. auf die zu bearbeitende Leiterkarte zu oder von der bearbeitenden Leiterkarte weg zu bewegen. Ein Verfahren der beiden Löttiegel entlang der X- und Y-Achse, d.h. in einer Ebene parallel zu einer zu bearbeitenden Leiterkarte erfolgt dabei immer synchron. Lötvorrichtungen mit Merkmalen des Oberbegriffs des Anspruchs 1 sind bspw. aus der DE 10 2004 063 488 A1, sowie aus der DE 10 2004 062 866 A1 bekannt. Aus der WO 2014/086954 A1 ist ferner eine Lötvorrichtung zum Selektivlöten mit Merkmalen des Oberbegriffs des Anspruchs 1 bekannt. Mit der aus der WO 2014/086954 A1 bekannten Lötvorrichtung ist es jedoch nur möglich, mehrere zu lötende Baugruppen (d.h. mehrere Leiterplatten bzw. Leiterkarten) gleichzeitig zu verlöten.

Bei der Verarbeitung von Leiterkartennutzen, d.h. von Gesamtleiterkarten, die aus einzelnen Leiterkarten mit bspw. mehrfach identischen Schaltungsfunktionen mit gleichem Aufbau besteht, jedoch noch nicht vereinzelt ist, hat es sich gezeigt, dass eine Bearbeitung von Leiterkartennutzen mit synchron verfahrenen Tiegeln insbesondere bei unterschiedlicher Orientierung der einzelnen Leiterkarten nicht erwünscht ist.

Der vorliegenden Erfindung liegt daher die Aufgabe zugrunde, ein Lötmodul für eine Lötanlage zum selektiven Wellenlöten bereitzustellen, mit dem eine Bearbeitung von Leiterkarten auf einfache und flexible Weise ermöglicht wird.

Diese Aufgabe wird durch ein Lötmodul mit den Merkmalen des Anspruchs 1 gelöst. Ein derartiges Lötmodul zeichnet sich dadurch aus, dass zwei Y-Achsenantriebe und zwei Verfahreinrichtungen vorgesehen sind, auf denen die Löttiegel entlang der Y-Achse mittels der Y-Achsenantriebe verlagerbar sind, wobei dem ersten Löttiegel eine erste Verfahreinrichtung zugeordnet ist und wobei dem zweiten Löttiegel eine zweite Verfahreinrichtung zugeordnet ist, die von der ersten Verfahreinrichtung verschieden ist, wobei das Lötmodul derart ausgelegt ist, dass eine einzelne Leiterkarte oder ein einzelner Leiterkartennutzen durch zwei Löttiegel gleichzeitig bearbeitet werden können.

Vorteilhafterweise umfasst ein jeweiliger Löttiegel jeweils eine Lötdüse und einen Behälter für flüssiges Lot, sowie eine Lotpumpe zum Fördern des flüssigen Lots zur Lötdüse. Es ist auch denkbar, dass ein Löttiegel mehrere Lötdüsen mit voneinander verschiedenen Düsendurchmessern umfasst. Ferner kann vorgesehen sein, dass ein Löttiegel auch eine Sprühdüse zum Aufbringen von Flussmittel, dem sogenannten Fluxen, umfasst. Es ist denkbar, dass in dem ersten Löttiegel und dem zweiten Löttiegel ein unterschiedliches Lötmaterial verwendet wird.

Durch Vorsehen zweier Y-Achsenantriebe und zweier Verfahreinrichtungen kann eine größere Variabilität des Lötmoduls erreicht werden, wobei nunmehr eine Bearbeitung von Leiterkartennutzen ermöglicht wird, wenn die Leiterkarten in Richtung der Y-Achse angeordnet sind.

Zur unabhängigen Verlagerung der Löttiegel auf den jeweiligen Verfahreinrichtungen entlang der Y-Achse hat es sich als besonders vorteilhaft erwiesen, wenn der erste Y-Achsenantrieb unabhängig vom zweiten Y-Achsenantrieb betreibbar ist.

Eine vorteilhafte Weiterbildung des Lötmoduls zeichnet sich dadurch aus, dass eine Führung vorgesehen ist, auf der die erste und die zweite Verfahreinrichtung entlang der X-Achse verfahrbar sind. Besonders bevorzugt ist es dabei, wenn der X-Achsenantrieb derart ausgelegt ist, dass die erste und die zweite Verfahreinrichtung unabhängig voneinander entlang der X-Achse verfahrbar sind.

Eine weitere vorteilhafte Weiterbildung des Lötmoduls zeichnet sich dadurch aus, dass die erste Verfahreinrichtung einer ersten Führung zugeorndet ist und auf der ersten Führung entlang der X-Achse verfahrbar ist, wobei die zweite Verfahreinrichtung einer zweiten Führung zugeorndet ist und auf der zweiten Führung entlang der X-Achse verfahrbar ist.

Als besonders vorteilhaft hat es sich dabei erwiesen, wenn zwei X-Achsenantriebe zum Verfahren der Verfahreinrichtungen auf der ersten und der zweiten Führung vorgesehen sind, die unabhängig voneinander betreibbar sind. Somit kann die erste Verfahreinrichtung auf der ersten Führung entlang der X-Achse verfahren werden, wobei die zweite Verfahreinrichtung auf der zweiten Führung entlang der X-Achse unabhängig von der ersten Verfahreinrichtung verfahren werden kann.

Vorteilhafterweise sind die Achsantriebe als Linearantriebe und/oder als Zahnstangenantriebe und/oder als Spindelantriebe und/oder als Zahnriemenantriebe ausgebildet. Dabei ist es auch denkbar, verschiedene Arten der Antriebe für verschiedene Achsrichtungen vorzusehen. Es hat sich jedoch als besonders vorteilhaft erwiesen, wenn die Achsantriebe als Linearantriebe, insbesondere als Linearmotoren ausgebildet sind.

In einer weiteren vorteilhaften Ausgestaltung des Lötmoduls ist vorgesehen, dass das Lötmodul eine Steuereinrichtung aufweist.

Dabei ist es besonders vorteilhaft, wenn die Steuereinrichtung zur Ansteuerung der Achsenantriebe derart ausgelegt ist, dass eine Kollision der Löttiegel vermieden wird.

Eine weitere kostengünstige Weiterbildung des Lötmoduls sieht vor, dass die Steuereinrichtung eine CNC-Steuerung umfasst, die derart ausgelegt ist, dass der erste Löttiegel und der zweite Löttiegel synchron verlagert werden. Vorteilhafterweise steuert die CNC-Steuerung die Achsantriebe, die dem ersten Löttiegel zugeordnet sind und die Achsantriebe, die dem zweiten Löttiegel zugeordnet sind synchron.

In einer besonders variablen Ausgestaltung des Lötmoduls ist vorgesehen, dass die Steuereinrichtung eine erste CNC-Steuerung umfasst, welche die Achsantriebe steuert, die dem ersten Löttiegel zugeordnet sind, und dass die Steuereinrichtung eine zweite CNC-Steuerung umfasst, welche die Achsantriebe steuert, die dem zweiten Löttiegel zugeordnet sind. Vorteilhafterweise steuert die erste CNC-Steuerung dann auch einen ersten Z-Achsenantrieb zum Verlagern des ersten Löttiegels entlang der Z-Achse, wobei die zweite CNC-Steuerung einen zweiten Z-Achsenantrieb zum Verlagern des zweiten Löttiegels entlang der Z-Achse steuert.

Wenn zwei separate CNC-Steuerungen vorgesehen sind, ist es denkbar, dass beide Löttiegel in demselben Arbeitsraum bewegt werden. In diesem Fall ist es besonders vorteilhaft, wenn die Steuereinrichtung zur Ansteuerung der Achsenantriebe derart ausgelegt ist, dass eine Kollision der Löttiegel vermieden wird. Es ist jedoch auch möglich, dass beide Löttiegel in separaten, voneinander verschiedenen Arbeitsräumen bewegt werden. Dabei kann beispielsweise im Rahmen einer Erstellung eines CNC-Programms sichergestellt werden, dass sich die Arbeitsbereiche der beiden Löttiegel nicht überlappen.

Zur Erhöhung der Variabilität des Lötmoduls erweist es sich als vorteilhaft, wenn der erste Löttiegel ein erstes Werkzeug, insbesondere eine erste Lötdüse aufweist und wenn der zweite Löttiegel ein zweites Werkzeug, insbesondere eine zweite Lötdüse aufweist, wobei das erste Werkzeug vom zweiten Werkzeug verschieden ist. Es ist auch denkbar, dass verschiedene Sprühdüsen zum Aufbringen von Flussmittel, d.h. verschiedene sogenannte Fluxerdüsen vorgesehen sind. Darüber hinaus ist es möglich, dass im ersten Löttiegel ein erstes Lot verwendet wird und im zweiten Löttiegel ein zweites Lot verwendet wird, das vom ersten Lot verschieden ist.

Die eingangs genannte Aufgabe wird auch gelöst durch eine Lötanlage zum selektiven Wellenlöten mit den Merkmalen des Anspruchs 13 sowie durch ein Verfahren zum Betreiben eines Lötmoduls mit den Merkmalen des Anspruchs 14.

Weitere Einzelheiten und vorteilhafte Ausgestaltungen der Erfindung sind der nachfolgenden Beschreibung zu entnehmen, anhand derer die in den Figuren dargestellten Ausführungsform der Erfindung näher beschrieben und erläutert ist.

Es zeigen:
- Figur 1: eine schematische Draufsicht auf ein erfindungsgemäßes Lötmodul für eine Lötanlage zum selektiven Wellenlöten in einer Ausgangsposition vor Bearbeitung einer Leiterkarte;
- Figur 2: eine schematische Draufsicht auf das Lötmodul gemäß Figur 1 bei der Bearbeitung einer Leiterkarte;
- Figur 3: eine schematische Draufsicht auf das Lötmodul gemäß der Figuren 1 und 2 bei einem in Y-Richtung minimierten Löttiegelabstand; und
- Figur 4: eine schematische Draufsicht auf das Lötmodul gemäß den Figuren 1 bis 3 bei einem in X-Richtung minimierten Löttiegelabstand.

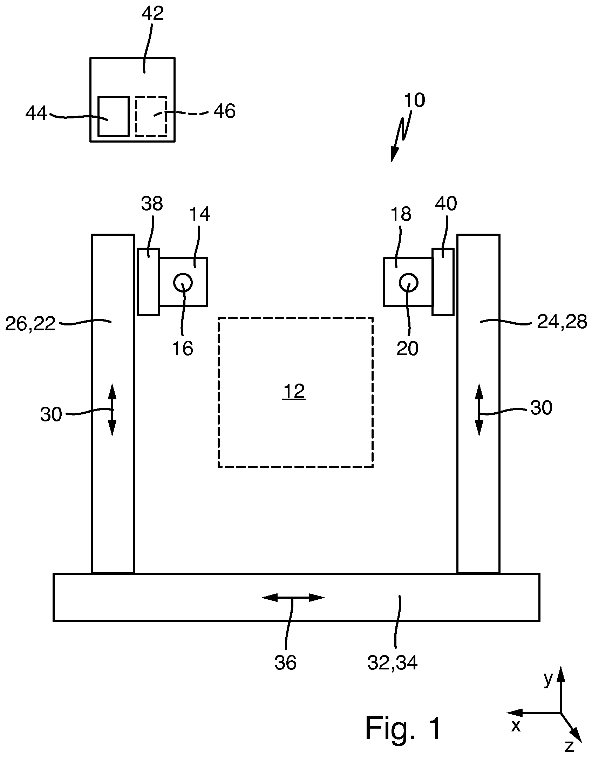

Die Figuren 1 bis 4 zeigen jeweils eine schematische Draufsicht auf ein erfindungsgemäßes Lötmodul 10 für eine Lötanlage zum selektiven Wellenlöten in verschiedenen Arbeitspositionen. Der Aufbau und die Funktionsweise des Lötmoduls 10 wird unter Bezugnahme auf die Figuren 1 bis 4 im Folgenden insgesamt erläutert. Sich entsprechende Bauteile und Elemente sind dabei mit den sich entsprechenden Bezugszeichen versehen.

Figur 1 zeigt eine Draufsicht auf ein erfindungsgemäßes Lötmodul 10 in einer Ausgangsposition vor Bearbeitung einer Leiterkarte 12. Das Lötmodul weist einen ersten Löttiegel 14 mit einer schematisch gezeigten Lötdüse 16 und einen zweiten Löttiegel 18 mit einer schematisch gezeigten Lötdüse 20 auf. Die Löttiegel 14, 18 weisen ferner nicht gezeigte Lötpumpen zum Erzeugen einer stehenden Welle eines flüssigen Lots auf, mit welchem durch eine Leiterkarte 12 von einer Oberseite hindurchgesteckte Bauelemente von einer Unterseite der Leiterkarte 12 kontaktiert werden können. Ferner können die Löttiegel 14, 18 ebenfalls nicht gezeigte Sprühdüsen zum Aufbringen eines Flussmittels aufweisen. Durch Aufbringen eines Flussmittels, sogenanntes Fluxen, kann eine Benetzung der Bauelemente durch das flüssige Lot verbessert werden.

Es ist denkbar, dass die Löttiegel 14, 18 verschiedene Lötdüsen 16, 20 aufweisen oder das in den Löttiegeln 14, 18 ein voneinander verschiedenes Lot verwendet wird.

Das Lötmodul 10 weist zwei Verfahreinrichtungen 22, 24 und zwei als Linearantriebe 26, 28 oder Linearmotoren ausgebildete Y-Achsenantriebe auf. Die Löttiegel 14, 18 sind auf den Verfahreinrichtungen 22, 24 mittels der Linearantriebe 26, 28 entlang einer durch Doppelpfeile 30 gekennzeichneten Y-Achsrichtung verlagerbar. Dem ersten Löttiegel 14 ist dabei die erste Verfahreinrichtung 22 sowie der erste Y-Achsenantrieb 26 zugeordnet, wobei dem zweiten Löttiegel 18 die zweite Verfahreinrichtung 24 sowie der zweite Y-Achsenantrieb 28 zugeordnet ist. Der erste und der zweite Y-Achsenantrieb 26, 28 sind unabhängig voneinander betreibbar.

Das Lötmodul 10 weist ferner eine Führung 32 auf, auf der die erste Verfahreinrichtung 22 sowie die zweite Verfahreinrichtung 24 mittels eines X-Achsenantriebs 34 entlang einer durch den Doppelpfeil 36 gekennzeichneten X-Achsenrichtung verfahrbar sind. Vorteilhafterweise ist der X-Achsenantrieb 34 ebenfalls als Linearmotor ausgebildet. Der X-Achsenantrieb 34 ist derart ausgelegt, dass die erste Verfahreinrichtung 22 und die zweite Verfahreinrichtung 24 unabhängig voneinander in der X-Achsenrichtung auf der Führung 32 verfahrbar sind.

Die Löttiegel 14, 18 sind an den Verfahreinrichtungen 22, 24 mittelbar über ebenfalls als Linearantriebe (Linearmotoren, Zahnstange, Riemen oder Spindel) ausgebildete Z-Achsenantriebe 38, 40 befestigt. Der erste Löttiegel 14 ist dabei an der ersten Verfahreinrichtung 22 mittels eines ersten Z-Achsenantriebs 38 befestigt, wobei der zweite Löttiegel 18 an der zweiten Verfahreinrichtung 24 mittels eines zweiten Z-Achsenantriebs 40 befestigt ist. Mittels der Z-Achsenantriebe können die Löttiegel 14, 18 in einer Richtung senkrecht zu einer durch die X- und Y-Achsenrichtung aufgespannten Ebene bewegt werden, d.h. in einer Richtung senkrecht zur Leiterkarte 12. Somit können die Löttiegel 14, 18 mittels der Z-Achsenantriebe 38, 40 auf die Leiterkarte 12 zu bewegt werden oder von der Leiterkarte weg bewegt werden. Die Z-Achsenantriebe 38, 40 sind unabhängig voneinander betreibbar, so dass die Löttiegel 14, 18 unabhängig voneinander auf die Leiterkarte 12 zu und von dieser weg bewegt werden können.

Das Lötmodul 10 weist eine Steuereinrichtung 42 auf, die zur Ansteuerung der Achsantriebe 26, 28, 34, 38, 40 derart ausgelegt ist, dass eine Kollision der Löttiegel 10 im Betrieb vermieden wird.

Die Steuereinrichtung 42 weist eine erste Achs- oder CNC-Steuerung 44 und eine optionale zweite Achs- oder CNC-Steuerung 46 auf.

Die Funktionsweise des Lötmoduls wird nunmehr anhand der Figuren 1 bis 4 erläutert.

Wenn die Steuereinrichtung zwei CNC-Steuerungen 44, 46 aufweist, können die Löttiegel 14, 18 vollkommen unabhängig voneinander verfahren werden, so dass eine Bearbeitung von Leiterkartennutzen in einer Anordnung in X- und Y-Richtung ermöglicht wird.

Figur 1 zeigt das Lötmodul 10 in einer Ausgangsposition vor Bearbeitung der Leiterkarte 12. Die Löttiegel 14, 18 befinden sich in einer Park-oder Serviceposition.

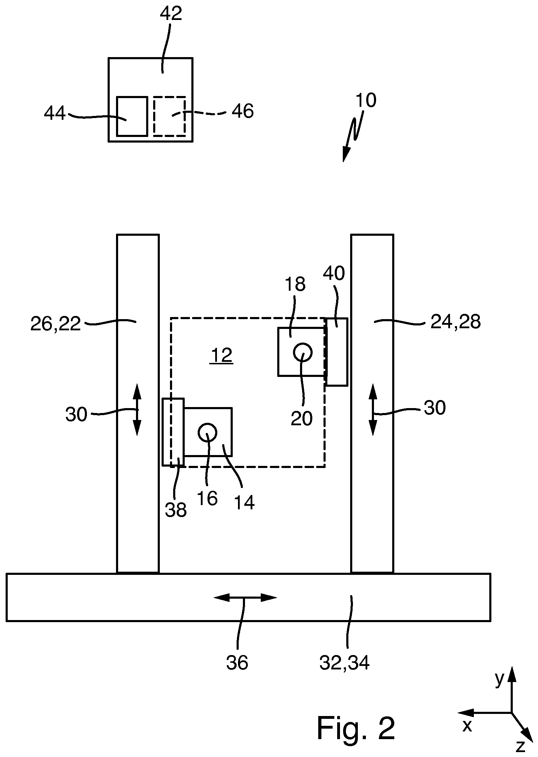

In Figur 2 ist das Lötmodul 10 bei der Bearbeitung der Leiterkarte 12 gezeigt, wobei die Löttiegel 14, 18 vollständig unabhängig voneinander verfahren werden. Die Steuereinrichtung 42 stellt dabei sicher, dass die Löttiegel 14, 18 nicht kollidieren können. Der erste Löttiegel 14 wird dabei verfahren indem die erste CNC-Steuerung 44 die dem ersten Löttiegel 14 zugeordneten Achsantriebe ansteuert, d.h. den X-Achsenantrieb 34, den ersten Y-Achsenantrieb 26 und den ersten Z-Achsenantrieb 38. Der zweite Löttiegel 18 wird verfahren indem die zweite CNC-Steuerung 46 die dem zweiten Löttiegel 18 zugeordneten Achsantriebe ansteuert, d.h. den X-Achsenantrieb 34, den zweiten Y-Achsenantrieb 28 und den zweiten Z-Achsenantrieb 40.

Die Löttiegel 14, 18 werden entlang vorprogrammierter Bahnen zweier verschiedener CNC-Programme bewegt. Eine in den Löttiegeln 14, 18 jeweils erzeugte stehende Welle flüssigen Lots kontaktiert dabei die auf der Leiterkarte 12 angeordneten Bauelemente von einer Unterseite der Leiterkarte 12.

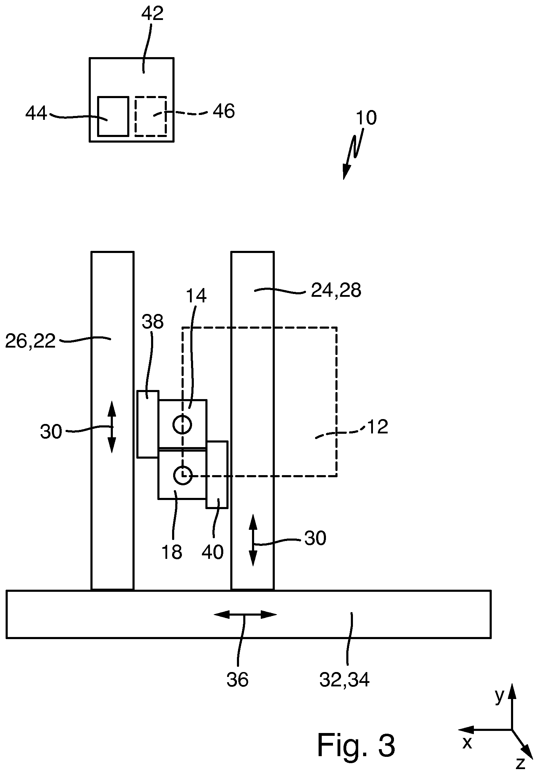

Mit dem erfindungsgemäßen Lötmodul 10 ist eine höchst variable Kontaktierung ermöglicht. Figur 3 zeigt beispielsweise eine Bearbeitungssituation, in der die Löttiegel 14, 18 in einen in Y-Richtung minimierten Löttiegelabstand verlagert sind.

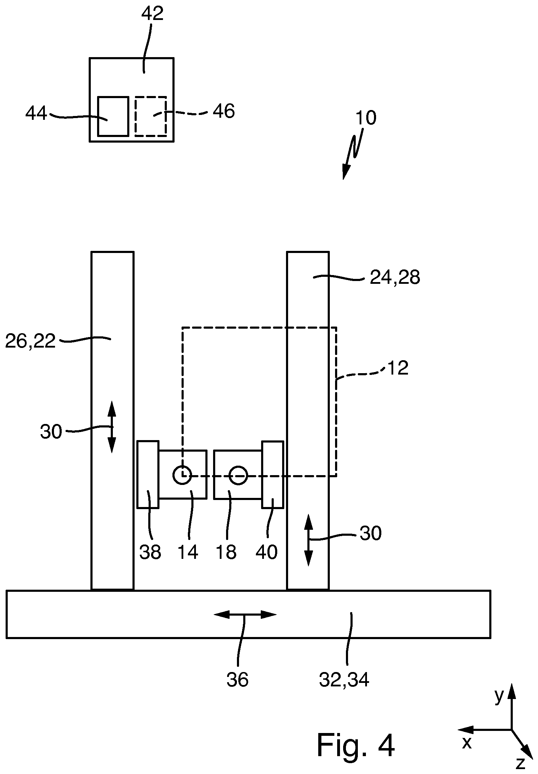

Figur 4 zeigt eine Bearbeitungssituation, in der die Löttiegel 14, 18 in einen in X-Richtung minimierten Löttiegelabstand verlagert sind.

In der in den Figuren 1 bis 4 dargestellten Situation werden die Löttiegel 14, 18 in einem gemeinsamen Arbeitsraum verfahren. Es ist jedoch auch denkbar, in den CNC-Steuerungen 44, 46 CNC-Programme vorzusehen, die für die Löttiegel 14, 18 jeweils getrennte Arbeitsräume vorsehen, so dass eine Kollision bereits aus Gründen der gewählten Verfahrbahn vermieden ist.

Es ist auch denkbar, dass die CNC-Steuerung 44 dann so ausgelegt ist, dass die Achsantriebe 26, 28, 34, 38, 40 derart angesteuert werden, dass die beiden Löttiegel 14, 18 synchron verlagert werden.

Insgesamt ist mit dem erfindungsgemäßen Lötmodul 10 eine hochvariable Bearbeitung beim selektiven Wellenlöten von Leiterkarten ermöglicht.

## Patentansprüche

1. Lötmodul (10) für eine Lötanlage zum selektiven Wellenlöten mit wenigstens einem ersten und einem zweiten Löttiegel (14, 18), wobei die Löttiegel mittels eines X-Achsenantriebs (34) entlang einer X-Achse verlagerbar sind, mittels eines Y-Achsenantriebs (26, 28) entlang einer Y-Achse verlagerbar sind, und mittels eines Z-Achsenantriebs (38, 40) entlang einer Z-Achse verlagerbar sind, wobei die Achsen jeweils orthogonal zueinander angeordnet sind, **dadurch gekennzeichnet, dass** zwei Y-Achsenantriebe (26, 28) und zwei Verfahreinrichtungen (22, 24) vorgesehen sind, auf denen die Löttiegel (14, 18) entlang der Y-Achse mittels der Y-Achsenantriebe (26, 28) verlagerbar sind, wobei dem ersten Löttiegel (14) eine erste Verfahreinrichtung (22) zugeordnet ist und wobei dem zweiten Löttiegel (18) eine zweite Verfahreinrichtung (24) zugeordnet ist, die von der ersten Verfahreinrichtung (22) verschieden ist, wobei das Lötmodul (10) derart ausgelegt ist, dass eine einzelne Leiterkarte (12) oder ein einzelner Leiterkartennutzen durch zwei Löttiegel (14, 18) gleichzeitig bearbeitet werden können.

2. Lötmodul (10) nach Anspruch 1, **dadurch gekennzeichnet, dass** der erste Y-Achsenantrieb (26) unabhängig vom zweiten Y-Achsenantrieb (28) betreibbar ist.

3. Lötmodul (10) nach Anspruch 1 oder 2, **dadurch gekennzeichnet, dass** eine Führung (32) vorgesehen ist, auf der die erste und die zweite Verfahreinrichtung (22, 24) entlang der X-Achse verfahrbar sind.

4. Lötmodul (10) nach Anspruch 1 oder 2, **dadurch gekennzeichnet dass** zwei Führungen (32) vorgesehen sind, wobei die erste Verfahreinrichtung (22) einer ersten Führung zugeorndet ist und auf der ersten Führung entlang der X-Achse verfahrbar ist und wobei die zweite Verfahreinrichtung (24) einer zweiten Führung zugeorndet ist und auf der zweiten Führung entlang der X-Achse verfahrbar ist.

5. Lötmodul (10) nach Anspruch 4, **dadurch gekennzeichnet, dass** zwei X-Achsenantriebe (34) zum Verfahren der Verfahreinrichtungen (22, 24) auf der ersten und der zweiten Führung vorgesehen sind, die unabhängig voneinander betreibbar sind.

6. Lötmodul (10) nach wenigstens einem der vorhergehenden Ansprüche, **dadurch gekennzeichnet, dass** die Achsantriebe (26, 28, 34, 38, 40) als Linearantriebe und/oder als Zahnstangenantriebe und/oder als Spindelantriebe und/oder als Zahnriemenantriebe ausgebildet sind.

7. Lötmodul (10) nach wenigstens einem der vorhergehenden Ansprüche, **dadurch gekennzeichnet, dass** das Lötmodul (10) eine Steuereinrichtung (42) aufweist.

8. Lötmodul (10) nach Anspruch 7, **dadurch gekennzeichnet, dass** die Steuereinrichtung (42) zur Ansteuerung der Achsenantriebe (26, 28, 34, 38, 40) derart ausgelegt ist, dass eine Kollision der Löttiegel (14, 18) vermieden wird.

9. Lötmodul (10) nach Anspruch 7 oder 8, **dadurch gekennzeichnet, dass** die Steuereinrichtung (42) eine CNC-Steuerung (44) umfasst, die derart ausgelegt ist, dass der erste Löttiegel (14) und der zweite Löttiegel (18) synchron verlagert werden.

10. Lötmodul (10) nach Anspruch 7 oder 8, **dadurch gekennzeichnet, dass** die Steuereinrichtung (42) eine erste CNC-Steuerung (44) umfasst, welche die Achsantriebe (26, 34, 38) steuert, die dem ersten Löttiegel (14) zugeordnet sind, und dass die Steuereinrichtung (42) eine zweite CNC-Steuerung (46) umfasst, welche die Achsantriebe (28, 34, 40) steuert, die dem zweiten Löttiegel (18) zugeordnet sind.

11. Lötmodul (10) nach wenigstens einem der vorhergehenden Ansprüche, **dadurch gekennzeichnet, dass** der erste Löttiegel (14) ein erstes Werkzeug, insbesondere eine erste Lötdüse (16) aufweist und dass der zweite Löttiegel (18) ein zweites Werkzeug, insbesondere eine zweite Lötdüse (20) aufweist, wobei das erste Werkzeug vom zweiten Werkzeug verschieden ist.

12. Lötanlage zum selektiven Wellenlöten umfassend ein Lötmodul (10) nach wenigstens einem der vorhergehenden Ansprüche.

13. Verfahren zum Betreiben eines Lötmoduls (10) für eine Lötanlage zum selektiven Wellenlöten nach wenigstens einem der Ansprüche 1 bis 12, **dadurch gekennzeichnet, dass** die Löttiegel (14, 18) in der X-, Y- und Z-Achse unabhängig voneinander verfahren werden und dass eine einzelne Leiterkarte (12) oder einzelne Leiterkartennutzen durch zwei Löttiegel (14, 18) gleichzeitig bearbeitet werden.

## Claims

1. A soldering module (10) for a soldering system for selective wave soldering, having at least one first and one second solder pot (14, 18), wherein the solder pots are displaceable along an x-axis by means of an x-axis drive (34), along a y-axis by means of a y-axis drive (26, 28), and along a z-axis by means of a z-axis drive (38, 40), wherein the axes are all arranged orthogonally in relation to each other, **characterized in that** two y-axis drives (26, 28) and two moving devices (22, 24) are provided on which the solder pots (14, 18) are displaceable along the y-axis by means of the y-axis drives (26, 28), wherein a first moving device (22) is associated with the first solder pot (14), and wherein a second moving device (24) which is different from the first moving device (22) is associated with the second solder pot (18), wherein the soldering module (10) being designed in such a way that a single printed circuit board (12) or a single printed circuit board panel can be processed simultaneously by two soldering pots (14, 18).

2. A soldering module (10) according to claim 1, **characterized in that** the first y-axis drive (26) can be operated independently of the second y-axis drive (28).

3. A soldering module (10) according to claim 1 or 2, **characterized in that** a guide (32) is provided on which the first and second moving device (22, 24) can be moved along the x-axis.

4. The soldering module (10) according to claim 1 or 2, **characterized in that** two guides (32) are provided, wherein the first moving device (22) is associated with a first guide and can be moved along the x-axis on the first guide, and wherein the second moving device (24) is associated with a second guide and can be moved along the x-axis on the second guide.

5. The soldering module (10) according to claim 4, **characterized in that** two x-axis drives (34) for moving the moving devices (22, 24) are provided on the first and second guide that can be operated independently of each other.

6. The soldering module (10) according to one of the preceding claims, **characterized in that** the axial drives (26, 28, 34, 38, 40) are designed as linear drives, and/or as rack and pinion drives, and/or as spindle drives, and/or as toothed belt drives.

7. The soldering module (10) according to one of the preceding claims, **characterized in that** the soldering module (10) has a control device (42).

8. The soldering module (10) according to claim 7, **characterized in that** the control device (42) is designed to actuate the axial drives (26, 28, 34, 38, 40) such that a collision of the solder pots (14, 18) during operation is avoided.

9. The soldering module (10) according to claim 7 or 8, characterize that the control device (42) comprises a CNC control (44) which is designed such that the first solder pot (14) and the second solder pot (18) are displaced in sync.

10. The solder module (10) according to claim 7 or 8, **characterized in that** the control device (42) comprises a first CNC control (44) that controls the axial drives (26, 34, 38) that are associated with the first solder pot (14), and the control device (42) comprises a second CNC control (46) that controls the axial drives (28, 34, 40) that are associated with the second solder pot (18).

11. The soldering module (10) according to one of the preceding claims, **characterized in that** the first solder pot (14) has a first tool, in particular a first solder nozzle (16), and **in that** the second solder pot (18) has a second tool, in particular a second solder nozzle (20), wherein the first tool is different from the second tool.

12. A soldering system for selective wave soldering, comprising a soldering module (10) according to at least one of the preceding claims.

13. A method for operating a soldering module (10) for a soldering system for selective wave soldering according to at least one of claims 1 to 12, **characterized in that** the solder pots (14, 18) move independently of each other in the x-, y-, and z-axis and that a single printed circuit board (12) or a single printed circuit board panel can be processed simultaneously by two soldering pots (14, 18).

## Revendications

1. Module de brasage (10) pour une installation de brasage pour le brasage sélectif à la vague avec au moins un premier et un deuxième creuset de brasage (14, 18), dans lequel les creusets de brasage peuvent être déplacés au moyen d'un entraînement d'axe X (34) le long d'un axe X, peuvent être déplacés au moyen d'un entraînement d'axe Y (26, 28) le long d'un axe Y, et peuvent être déplacés au moyen d'un entraînement d'axe Z (38, 40) le long d'un axe Z, dans lequel les axes sont disposés respectivement perpendiculairement les uns aux autres, **caractérisé en ce que** deux entraînements d'axe Y (26, 28) et deux dispositifs de déplacement (22, 24) sont prévus, sur lesquels les creusets de brasage (14, 18) peuvent être déplacés le long de l'axe Y au moyen des entraînements d'axe Y (26, 28), dans lequel un premier dispositif de déplacement (22) est associé au premier creuset (14) et dans lequel un deuxième dispositif de déplacement (24), qui est différent du premier dispositif de déplacement (22), est associé au deuxième creuset (18), dans lequel le module de brasage (10) est conçu de telle sorte qu'une carte de circuits imprimés (12) individuelle ou un flanc de carte de circuits imprimés individuel peuvent être usinés simultanément par deux creusets de brasage (14, 18).

2. Module de brasage (10) selon la revendication 1, **caractérisé en ce que** le premier entraînement d'axe Y (26) peut fonctionner indépendamment du deuxième entraînement d'axe Y (28).

3. Module de brasage (10) selon la revendication 1 ou 2, **caractérisé en ce qu'**un guidage (32) est prévu, sur lequel le premier et le deuxième dispositif de déplacement (22, 24) peuvent être déplacés le long de l'axe X.

4. Module de brasage (10) selon la revendication 1 ou 2, **caractérisé en ce que** deux guidages (32) sont prévus, dans lequel le premier dispositif de déplacement (22) est associé à un premier guidage et peut être déplacé sur le premier guidage le long de l'axe X et dans lequel le deuxième dispositif de déplacement (24) est associé à un deuxième guidage et peut être déplacé sur le deuxième guidage le long de l'axe X.

5. Module de brasage (10) selon la revendication 4, **caractérisé en ce que** deux entraînements d'axe X (34) sont prévus pour le déplacement des dispositifs de déplacement (22, 24) sur le premier et le deuxième guidage, qui peuvent fonctionner indépendamment l'un de l'autre.

6. Module de brasage (10) selon au moins l'une des revendications précédentes, **caractérisé en ce que** les entraînements d'axe (26, 28, 34, 38, 40) sont réalisés sous la forme d'entraînements linéaires et/ou sous la forme d'entraînements à crémaillère et/ou sous la forme d'entraînements à broche et/ou sous la forme d'entraînements à courroie crantée.

7. Module de brasage (10) selon au moins l'une des revendications précédentes, **caractérisé en ce que** le module de brasage (10) présente un dispositif de commande (42).

8. Module de brasage (10) selon la revendication 7, **caractérisé en ce que** le dispositif de commande (42) est conçu pour commander les entraînements d'axe (26, 28, 34, 38, 40) de telle sorte qu'une collision des creusets de brasage (14, 18) soit évitée.

9. Module de brasage (10) selon la revendication 7 ou 8, **caractérisé en ce que** le dispositif de commande (42) comprend une commande numérique par ordinateur (44), qui est conçue de telle sorte que le premier creuset de brasage (14) et le deuxième creuset de brasage (18) sont déplacés de manière synchrone.

10. Module de brasage (10) selon la revendication 7 ou 8, **caractérisé en ce que** le dispositif de commande (42) comprend une première commande numérique par ordinateur (44), laquelle commande les entraînements d'axe (26, 34, 38), qui sont associés au premier creuset de brasage (14), et **en ce que** le dispositif de commande (42) comprend une deuxième commande numérique par ordinateur (46), laquelle commande les entraînements d'axe (28, 34, 40) qui sont associés au deuxième creuset de brasage (18).

11. Module de brasage (10) selon au moins l'une des revendications précédentes, **caractérisé en ce que** le premier creuset de brasage (14) présente un premier outil, en particulier une première buse de brasage (16) et **en ce que** le deuxième creuset de brasage (18) présente un deuxième outil, en particulier une deuxième buse de brasage (20), dans lequel le premier outil est différent du deuxième outil.

12. Installation de brasage pour le brasage sélectif à la vague comprenant un module de brasage (10) selon au moins l'une des revendications précédentes.

13. Procédé pour faire fonctionner un module de brasage (10) pour une installation de brasage pour le brasage sélectif à la vague selon au moins l'une des revendications 1 à 12, **caractérisé en ce que** les creusets de brasage (14, 18) sont déplacés indépendamment l'un de l'autre dans l'axe X, Y et Z et **en ce qu'**une carte de circuits imprimés (12) individuelle ou des flancs de carte de circuits imprimés individuels sont usinés simultanément par deux creusets de brasage (14, 18).
